# EUROPEAN PATENT APPLICATION

(11) **EP 4 700 306 A1**
(43) Date of publication of application: **25.02.2026**
(21) Application number: 24935525.6
(22) Date of filing: 29.05.2024
(51) Int. Cl.: F25B 9/00, H01F 6/04, F25B 41/40, F25B 41/26

(54) **OFFLINE SYSTEM FOR SUPERCONDUCTING MAGNET AND REFRIGERATION ASSEMBLY**

(30) Priority: 16.04.2024 CN 202410456368
(71) Applicant: CRRC Changchun Railway Vehicles Co., Ltd., Changchun, Jilin 130000 (CN)
(72) Inventor: LI, Kai, Changchun, Jilin 130000 (CN); LIU, Hongtao, Changchun, Jilin 130000 (CN); YU, Qingsong, Changchun, Jilin 130000 (CN); TAN, Fuxing, Changchun, Jilin 130000 (CN)
(74) Representative: Lorenz Seidler Gossel Part. mbB
(86) International application number: PCT/CN2024/096037
(87) International publication number: WO 2025/217990

(57) **Abstract**

The present application is applied to the technical field of superconducting applications, and discloses an offline system for a superconducting magnet and a refrigeration assembly, comprising a helium gas pipe assembly, a cold head, a self-sealing joint set, a two-position four-way valve set, a compressor, and a power supply that supplies power to the compressor. **In** the present application, the compressor and the cold head are connected by means of the helium gas pipe assembly, helium gas is used as a medium in contact with a thermal interface, and self-sealing joints are arranged at the connection and disconnection points of helium gas pipelines, so that the problems such as frost formation at the thermal interface can be avoided, greatly reducing the offline-to-reconnection time of the system. **In** addition, no foreign gas is introduced during the entire offline-to-reconnection process, thereby improving the reliability of the offline system for the superconducting magnet and the refrigeration assembly.

## Description

The present application claims the priority to Chinese Patent Application No. 202410456368.2, titled "SYSTEM FOR DISCONNECTING SUPERCONDUCTING MAGNET FROM REFRIGERATION UNIT", filed with the China National Intellectual Property Administration on April 16, 2024, which is incorporated herein by reference in its entirety.

### FIELD

The present application relates to the technical field of superconducting applications and, in particular, to a system for disconnecting a superconducting magnet from a refrigeration unit.

### BACKGROUND

A superconducting magnet, as a critical core component of a maglev train, is primarily used to provide a strong magnetic field necessary for traction, levitation and guidance of the maglev train.

The superconducting magnet is required to undergo tests on relevant performances in a prototype stage to meet high safety and reliability requirements for service. In some tests, the superconducting magnet is required to be disconnected from a refrigeration unit in operation, e.g., to be tested in a disconnected state, and, after the testing, to be reconnected to the refrigeration unit to dissipate heat generated during the disconnected period and restore the internal temperature of the superconducting magnet. Such disconnection and reconnection process is generally desired to be lossless and reversible, so that a consistent internal temperature condition of the superconducting magnet is available for the next disconnected testing. This temperature condition directly influences performances of the superconducting magnet.

In conventional devices for disconnecting a superconducting magnet from a refrigeration unit, a thermal interface is directly exposed to air upon disconnection. Prior to reconnection, it takes a long time to address issues such as frost formation on the thermal interface, thereby affecting an efficiency of testing the superconducting magnet and a temperature of superconducting coils. Furthermore, foreign gas may be introduced during the reconnection, thereby affecting the restoration of the superconducting magnet in its operation states after reconnected to the refrigeration unit. In summary, the device for disconnecting the superconducting magnet from the refrigeration unit exhibits a low reliability.

### SUMMARY

In view of this, a system for disconnecting a superconducting magnet from a refrigeration unit is provided according to the present application, which can address the issue of the low reliability of the conventional device for disconnecting the superconducting magnet from the refrigeration unit.

In order to address the above issue, the following solutions are provided according to the present application.

A system for disconnecting a superconducting magnet from a refrigeration unit includes a helium gas pipe set, a cold head, a self-sealing connector set, a two-position four-way valve set, a compressor, and a power supply for supplying electricity to the compressor.

The helium gas pipe set includes a first helium gas pipeline and a second helium gas pipeline.

The cold head includes an outlet pipe connected to a return pipe of the compressor via the first helium gas pipeline, and an inlet pipe connected to an outlet pipe of the compressor via the second helium gas pipeline. Each of the outlet pipe of the cold head, the inlet pipe of the cold head, the return pipe of the compressor and the outlet pipe of the compressor is provided with a self-sealing connector for achieving connection or disconnection of the helium gas pipelines.

The two-position four-way valve set includes a first two-position four-way valve and a second two-position four-way valve. The first two-position four-way valve is connected between the outlet pipe and the inlet pipe of the cold head, and is configured to control the cold head to be in a disconnected operation condition or a reconnection condition. The second two-position four-way valve is connected between the return pipe and the outlet pipe of the compressor, and is configured to control the compressor to be in a balanced pressure condition or a normal condition.

Optionally, a ball valve set is further included.

The ball valve set includes a first ball valve and a second ball valve. The first ball valve is disposed at the return pipe of the compressor, and is configured to obstruct the return pipe of the compressor in a maintenance condition. The second ball valve is disposed at the outlet pipe of the compressor, and is configured to obstruct the outlet pipe of the compressor in the maintenance condition.

Optionally, a pressure gauge set is further included to indicate pressures in the helium gas pipelines.

The pressure gauge set includes a first pressure gauge connected to the first two-position four-way valve, and a second pressure gauge connected to the second two-position four-way valve.

Optionally, a needle valve set is further included to relieve pressure.

The needle valve set includes a first needle valve connected to the first two-position four-way valve, and a second needle valve connected to the second two-position four-way valve.

Optionally, an adjustable pressure relief valve is further included.

The adjustable pressure relief valve is connected to the first two-position four-way valve and is configured to discharge residual gas out of the helium gas pipelines.

Optionally, in a disconnected operation state,
the power supply is in a de-energized state;
each of the first helium gas pipeline and the second helium gas pipeline is in a disconnected state; and
the first two-position four-way valve is adjusted to bring the cold head into the disconnected operation condition, and the second two-position four-way valve is adjusted to bring the compressor into the balanced pressure condition.

Optionally, the following is further included:
the adjustable pressure relief valve initiates pressure relief when a cracking pressure of the adjustable pressure relief valve is reached, and is automatically closed once the pressure relief is completed.

Optionally, in the reconnection state,
the power in an energized state;
each of the first helium gas pipeline and the second helium gas pipeline is in a communicated state; and
the first and second position four-way valve is adjusted to bring the cold head into the reconnection condition.

Optionally, maintenance state is further included.

The maintenance state includes a maintenance state on on-board side, a maintenance state on ground side, and a setting state of the adjustable pressure relief valve. The on-board side refers to a side where the cold head is located, and the ground side refers to a side where the compressor is located.

Optionally, the following is included:
in the maintenance state on the on-board side, the first second-position four-way valve is adjusted to bring the cold head into the disconnected operation condition, and the first needle valve is opened to empty the helium gas pipelines on the on-board side and then is closed;
in the maintenance state on the ground side, the second two-position four-way valve is adjusted to bring the compressor into the balanced pressure condition, and the second needle valve is opened empty the helium gas pipelines on the ground side and then is closed;
in the setting state of the adjustable pressure relief valve, the first two-position four-way valve is adjusted to bring the cold head into the disconnected operation condition, and the adjustable pressure relief valve is adjusted while observing the first pressure gauge until the first pressure gauge indicates a required set pressure.

As can be seen from the above solutions, the system for disconnecting the superconducting magnet from the refrigeration unit according to the present application includes a helium gas pipe set, a cold head, a self-sealing connector set, a two-position four-way valve set, a compressor, and a power supply for supplying electricity to the compressor. In the present application, by connecting the compressor and the cold head via the helium gas pipe set, using helium gas as a medium in contact with the thermal interface, and providing self-sealing connectors at parts of the helium gas pipelines to be connected and disconnected, it is possible to prevent frost formation on the thermal interface and other issues, significantly shortening the duration required for disconnection and reconnection of the system. In addition, no foreign gas is introduced during the entire disconnection and reconnection process, thereby improving the reliability of the system for disconnecting the superconducting magnet from the refrigeration unit.

### BRIEF DESCRIPTION OF THE DRAWINGS

For more clearly illustrating embodiments of the present application or the technical solutions in the conventional technology, drawings referred to describe the embodiments or the conventional technology will be briefly described hereinafter. Apparently, the drawings in the following description are only some examples of the present application, and for those skilled in the art, other drawings may be obtained based on these drawings without any creative efforts.
FIG. 1 is a diagram showing structure of a system for disconnecting a superconducting magnet from a refrigeration unit according to the present application; and
FIG. 2 is a diagram showing an example of structure of the system for disconnecting the superconducting magnet from the refrigeration unit according to the present application.

Reference numerals are listed as follows:

| | | | |
|---|---|---|---|
| 1. | first helium gas pipeline; | 2. | second helium gas pipeline; |
| 3. | outlet pipe of cold head; | 4. | inlet pipe of cold head; |
| 5. | return pipe of compressor; | 6. | outlet pipe of compressor; |
| 7. | self-sealing connector; | 8. | first two-position four-way valve; |
| 9. | second two-position four-way valve; | 10. | first ball valve; |
| 11. | second ball valve; | 12. | first pressure gauge; |
| 13. | second pressure gauge; | 14. | first needle valve; |
| 15. | second needle valve; | 16. | adjustable pressure relief valve; |
| 17. | power supply. | | |

### DETAILED DESCRIPTION OF THE EMBODIMENTS

Technical solutions according to the embodiments of the present application will be described clearly and completely as follows with reference to the accompany drawings by means of the embodiments of the present application. It is obvious that the described embodiments are only a part of the embodiments according to the present application, rather than all of the embodiments. All the other embodiments obtained by those skilled in the art based on the embodiments in the present application without any creative work belong to the scope of protection of the present application.

As used herein, the term "include" and variations thereof is inclusive, meaning "including but not limited to". The term "based on" means "at least partially based on". The term "an embodiment" means "at least one embodiment", the term "another embodiment" means "at least one another embodiment", and the term "some embodiments" means "at least some embodiments". Other terms are defined in the following description.

It should be noted that the terms "first" and "second" and so on mentioned in the present application are only used to distinguish different devices, modules or units, rather than to limit an order or interdependence of the functions performed by the devices, modules or units.

It should be noted that the terms "a" and "multiple" mentioned in the present application are illustrative rather than restrictive, and should be understood as "one or more" by those skilled in the art, unless otherwise explicitly indicated in the context.

A superconducting magnet is an electromagnet made of superconducting coils, and can conduct electric current without electrical-resistance or magnetic loss at an extremely low temperature, and generate a strong magnetic field around it. Below its critical temperature, the superconducting magnet maintains superconducting capability. The superconducting magnet includes a high-temperature superconducting magnet, which is made of coils wound with a high-temperature superconducting strip, can generate a strong magnetic field when energized, and is a critical core component of a maglev train. Relevant tests such as an electrodynamic suspension test, a traction test, and a speed profile test on a vehicle are required to be conducted in a prototype stage.

In a scaled-down maglev test, a vehicle undergoing the scaled-down maglev test serves as a minimal system powered by batteries. However, an on-board power supply cannot meet energy consumption requirements of a cryogenic refrigeration system for a superconducting magnet, i.e., cannot satisfy the high power consumption demand. Therefore, in a known technology, a ground power supply is used to continuously provide electricity to a cryocooler for superconducting magnets. Additionally, the loading capacity of the scaled-down vehicle undergoing the test is limited, so that a compressor and water chiller of the cryogenic refrigeration system cannot be mounted on the vehicle. In summary, in conventional tests for superconducting magnets, neither the on-board power supply nor the loading capacity can meet operational requirements of a refrigeration unit for superconducting magnets.

In view of power supply and loading capacity, it is proposed to disconnect a superconducting magnet in testing from a cryogenic refrigeration unit, and, after the testing, to reconnect the superconducting magnet to the cryogenic refrigeration unit to restore its state where it was prior to disconnection.

During actual testing, after the superconducting magnet is disconnected from the cryogenic refrigeration unit, an internal temperature of the superconducting material gradually increases. When it reaches a quench temperature of the superconducting material, the superconducting magnet undergoes demagnetization, failing to meet the testing requirements of the test system. Additionally, a maximum duration of disconnected operation must be considered for the superconducting magnet. In actual testing, when a conventional testing device for superconducting magnets is operated in the disconnected state, issues such as frosting may occur on the thermal interface. Thus, operations such as defrosting the thermal interface must be performed prior to reconnection, taking a certain amount of time. The more the time is taken in the process of disconnecting from and reconnecting to the cryocooler, the less the available testing time remains, failing to ensure both the validity and efficiency of the test for the superconducting magnet. During conventional testing process of the superconducting magnet disconnecting from and reconnecting to the refrigeration unit, foreign gas may be introduced during the reconnection, thereby affecting a testing result of the superconducting magnet. In summary, the conventional device for disconnecting the superconducting magnet from the refrigeration unit exhibits a low reliability.

In order to solve the above problems, there is provided in the present application a system for disconnecting a superconducting magnet from a refrigeration unit.

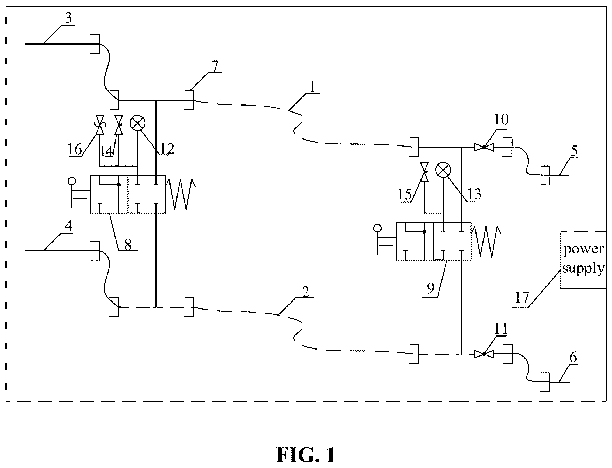

Reference is made to FIG. 1, which is a diagram showing structure of a system for disconnecting a superconducting magnet from a refrigeration unit according to the present application.

The system for disconnecting the superconducting magnet from the refrigeration unit includes a helium gas pipe set, a cold head, a self-sealing connector set, a two-position four-way valve set, a compressor, and a power supply 17 for supplying electricity to the compressor. The power supply 17 may be provided in the compressor or in a power distribution cabinet.

For this solution, the inventor proposes dividing the system into an on-board side and a ground side. The cold head and a part of the helium gas pipelines remain on the vehicle, whereas a helium compressor, a water chiller, and the remaining part of the helium gas pipelines are located on the ground. By incorporating additional assemblies in the helium gas pipelines, the superconducting magnet can be rapidly and losslessly disconnected from a cryogenic refrigeration system (also referred to as a cryocooler or a refrigeration unit). Dividing the system into the on-board side and the ground side can ensure sufficient power supply to meet energy consumption requirements of the cryogenic refrigeration system for the superconducting magnet, i.e., to satisfy high power consumption demand. It should be noted that the cryogenic refrigeration system primarily provides a cryogenic environment for superconducting magnets.

As shown in FIG. 1, the helium gas pipe set includes a first helium gas pipeline 1 and a second helium gas pipeline 2. The cold head includes an outlet pipe 3 connected to a return pipe 5 of the compressor via the first helium gas pipeline 1, and an inlet pipe 4 connected to an outlet pipe 6 of the compressor via the second helium gas pipeline 2. It should be noted that the cold head is a component of a refrigeration device, and has a refrigeration end in the form of a copper block that is connected to a structure to be cooled. The cold head is connected to the helium gas pipe set. Helium gas in the helium gas pipelines serves as a cooling medium to provide constant cryogenic cooling for the superconducting coils. In addition, the cold head is installed in the superconducting magnet on the vehicle, and the compressor is installed on the ground. It can be understood that the helium gas pipe set connects the ground and on-board components.

The individual self-sealing connectors 7 in the self-sealing connector set is installed at the outlet pipe 3 of the cold head, the inlet pipe 4 of the cold head, the return pipe 5 of the compressor and the outlet pipe 6 of the compressor. The self-sealing connector is primarily used for connection or disconnection of the superconducting magnet. After the helium gas pipe set is disconnected, the self-sealing connector 7 may automatically seal to prevent external air from contaminating the original high-purity helium in the pipelines, thereby avoiding the introduction of foreign gas that could affect the cooling efficiency.

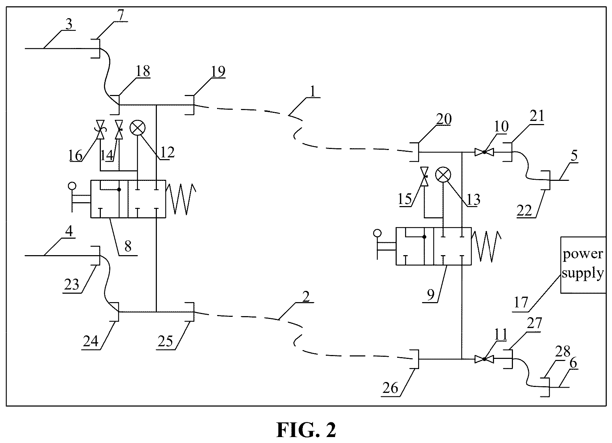

Specifically, reference is made to FIG. 2, which is a diagram showing an example of structure of the system for disconnecting the superconducting magnet from the refrigeration unit according to the present application. The self-sealing connector set includes male and female connectors. The male connector may include self-sealing connectors 7, 19, 21, 23, 25 and 27, and the corresponding female connector may include self-sealing connectors 18, 20, 22, 24, 26 and 28. It can be understood that the self-sealing connectors in the self-sealing connector set are configured in pairs and may be interchanged.

The two-position four-way valve set includes a first two-position four-way valve 8 and a second two-position four-way valve 9. The first two-position four-way valve 8 is located on the on-board side and connected between the outlet pipe 3 and the inlet pipe 4 of the cold head, and is primarily used to control operation states of the cold head mainly including a disconnected operation condition and a reconnection condition. By adjusting the first two-position four-way valve 8, the cold head may be controlled to be in the disconnected operation condition or the reconnection condition.

The second two-position four-way valve 9 is connected between the return pipe 5 and the outlet pipe 6 of the compressor, and is primarily used to control operation conditions of the compressor mainly including a balanced pressure condition and a normal condition. By adjusting the second two-position four-way valve 9, the compressor may be controlled to be in the balanced pressure condition or the normal condition. It should be noted that the normal condition is one that allows for cooling operation. High-pressure helium gas coming from the outlet pipe 6 of the compressor is supplied to the cold head, and low-pressure helium gas discharged from the cold head is returned into the compressor through the return pipe 5 of the compressor. During this process, helium gas circulates as a cooling medium within the helium gas pipelines, removing heat from a cold end of the cold head.

The system for disconnecting the superconducting magnet from the refrigeration unit further includes a ball valve set, a pressure gauge set, a needle valve set and an adjustable pressure relief valve 16.

The ball valve set is only provided on the ground side. The ball valve set includes a first ball valve 10 and a second ball valve 11. The first ball valve 10 is disposed at the return pipe 5 of the compressor, and is primarily used to block the return pipe 5 of the compressor, for example, in a maintenance condition. The second ball valve 11 is disposed at the outlet pipe 6 of the compressor, and is primarily used to block the outlet pipe 6 of the compressor, for example, in the maintenance condition.

The pressure gauge set includes a first pressure gauge 12 and a second pressure gauge 13, and is primarily used to indicate pressures in the helium gas pipelines. The first pressure gauge 12 is connected to the first two-position four-way valve 8, and the second pressure gauge 13 is connected to the second two-position four-way valve 9. It should be noted that, when the compressor is operated in the normal condition, the pressure difference between the return pipe 5 and the outlet pipe 6 of the compressor varies. When the compressor is operated in the balanced pressure condition, no gas flows through the return pipe 5 and the outlet pipe 6 of the compressor, and the second pressure gauge 13 indicates a stable reading.

The needle valve set includes a first needle valve 14 and a second needle valve 15, and is primarily used for pressure relief in a maintenance condition. The first needle valve 14 is connected to the first two-position four-way valve 8, and the second needle valve 15 is connected to the second two-position four-way valve 9. Specifically, the needle valves may be manually operated for pressure relief.

The adjustable pressure relief valve 16 is primarily used to discharge residual gas generated in the helium gas pipelines due to increased pressure caused by temperature rise. The adjustable pressure relief valve 16 is connected to the first two-position four-way valve 8. Specifically, a cracking pressure of the adjustable pressure relief valve 16 may be set, for example, to 2 Bar below a maximum allowable pressure of the helium gas pipelines.

In summary, the system for disconnecting the superconducting magnet from the refrigeration unit according to the present application includes a helium gas pipe set, a cold head, a self-sealing connector set, a two-position four-way valve set, a compressor, and a power supply for supplying electricity to the compressor. In the present application, by connecting the compressor and the cold head via the helium gas pipe set, using helium gas as a medium in contact with the thermal interface, and providing self-sealing connectors at the parts of the helium gas pipelines to be connected or disconnected, it is possible to prevent frost formation on the thermal interface and other issues, significantly shortening the duration required for disconnection and reconnection of the system. In addition, no foreign gas is introduced during the entire disconnection and reconnection process, thereby improving the reliability of the system for disconnecting the superconducting magnet from the refrigeration unit.

The above-described system for disconnecting the superconducting magnet from the refrigeration unit primarily involves three states: a disconnected operation state, a reconnection state and a maintenance state.

Adjusting the system for disconnecting the superconducting magnet from the refrigeration unit to be in the disconnected operation state includes the following operations.
1) The power supply 17 for supplying electricity to the compressor is de-energized.
2) The first two-position four-way valve 8 is manually adjusted to bring the cold head into the disconnected operation condition.
3) The second two-position four-way valve 9 is manually adjusted to bring the compressor into the balanced pressure condition, so as to equalize internal pressures in the first helium gas pipeline 1 and the second helium gas pipeline 2, following which the second two-position four-way valve 9 automatically returns to its position where it is in the normal condition.
4) The self-sealing connector 19 is disconnected from the self-sealing connector 20, and the self-sealing connector 25 is disconnected from the self-sealing connector 26, so as to complete disconnected operations.

In summary, in the disconnected state, the power supply 17 is in a de-energized state; each of the first helium gas pipeline 1 and the second helium gas pipeline 2 is in a disconnected state; the cold head is in the disconnected operation condition; and the compressor is in the balanced pressure condition.

It should be noted that, in the disconnected state, the pressure of the residual gas in the helium gas pipelines gradually increases with temperature rise. When the pressure reaches the cracking pressure of the adjustable pressure relief valve 16, the adjustable pressure relief valve 16 is opened to relieve pressure in the pipelines, and is automatically closed once the pressure relief is complete. By providing the adjustable pressure relief valve 16, it is possible to prevent damage to the helium gas pipelines and prolong their service life.

Adjusting the system for disconnecting the superconducting magnet from the refrigeration unit to be in the reconnection state includes the following operations.
1) The self-sealing connector 19 is connected to the self-sealing connector 20, and the self-sealing connector 25 is connected to the self-sealing connector 26.
2) The first two-position four-way valve 8 is manually adjusted to bring the cold head into the reconnection condition.
3) The power supply 17 is energized, so as to complete reconnection operations.

In summary, in the reconnection state, the power supply 17 is in an energized state; each of the first helium gas pipeline 1 and the second helium gas pipeline 2 is in a communicated state; and the cold head is in the reconnection condition.

The maintenance condition corresponding to the maintenance state mainly includes a maintenance state on the on-board side, a maintenance state on the ground side and a setting state of the adjustable pressure relief valve.

The maintenance state on the on-board side primarily refers to a state of the system for disconnecting the superconducting magnet from the refrigeration unit when performing maintenance on components on the side where the cold head is located. In this case, the system for disconnecting the superconducting magnet from the refrigeration unit is operated as follows.
1) The first two-position four-way valve 8 is operated to bring the cold head into the disconnected operation state.
2) The first needle valve 14 is opened until the helium gas pipelines on the on-board side are drained. In this step, the needle valve is used for pressure relief, since component replacement is impossible when the pressure in the helium gas pipelines is high.

The maintenance state on the ground side primarily refers to a state of the system for disconnecting the superconducting magnet from the refrigeration unit when performing maintenance on components on the side where the compressor is located. In this case, the system for disconnecting the superconducting magnet from the refrigeration unit is operated as follows.
1) The second two-position four-way valve 98 is operated to bring the compressor into the balanced pressure condition.
2) The second needle valve 15 is opened until the helium gas pipelines on the ground side are drained.

In the setting state of the adjustable pressure relief valve, the first two-position four-way valve 8 is adjusted to bring the cold head into in the disconnected operation condition, and the adjustable pressure relief valve 16 is adjusted while observing the first pressure gauge 12 until the first pressure gauge 12 indicates a required set pressure.

In summary, the disconnected operation of the system for disconnecting the superconducting magnet from the refrigeration unit according to the present application is simple, quick and easy to implement. In actual applications, a disconnection or reconnection process can be completed in just 20 seconds, leaving ample time for vehicle testing.

It should be noted that the embodiments in this specification are described in a progressive manner, and each embodiment focuses on the differences from other embodiments. The same or similar parts between the embodiments may be referenced to each other.

Finally, it should be noted that, the relational terms such as "first", "second", "third", and "fourth" herein are used only to distinguish one entity or operation from another, rather than to necessitate or imply any actual relationship or order between these entities or operations. Moreover, the terms "comprise", "include" or any other variations thereof are intended to cover non-exclusive inclusion, such that a process, a method, an object or a device including a series of factors not only includes the listed factors, but also includes other factors not explicitly listed, or inherent factors of the process, the method, the object or the device. Without more limitations, a factor defined by a phrase "include one..." does not exclude a case that there is another same factor in the process, the method, the object or the device including the described factor.

Hereinabove described are only preferred embodiments of the present application. It should be noted that improvements and modifications may be made by those skilled in the art without departing from the principles of the present application, and such improvements and modifications fall within the scope of protection of the present application.

## Claims

1. A system for disconnecting a superconducting magnet from a refrigeration unit, comprising:
a helium gas pipe set;
a cold head;
a self-sealing connector set;
a two-position four-way valve set;
a compressor; and
a power supply for supplying electricity to the compressor,
wherein the helium gas pipe set comprises a first helium gas pipeline and a second helium gas pipeline;
wherein the cold head comprises an outlet pipe connected to a return pipe of the compressor via the first helium gas pipeline, and an inlet pipe connected to an outlet pipe of the compressor via the second helium gas pipeline; and each of the outlet pipe of the cold head, the inlet pipe of the cold head, the return pipe of the compressor and the outlet pipe of the compressor is provided with a self-sealing connector for achieving connection or disconnection of the helium gas pipelines; and
wherein the two-position four-way valve set comprises a first two-position four-way valve and a second two-position four-way valve, the first two-position four-way valve is connected between the outlet pipe and the inlet pipe of the cold head, and is configured to control the cold head to be in a disconnected operation condition or a reconnection condition, and the second two-position four-way valve is connected between the return pipe and the outlet pipe of the compressor, and is configured to control the compressor to be in a balanced pressure condition or a normal condition.

2. The system for disconnecting the superconducting magnet from the refrigeration unit according to claim 1, further comprising a ball valve set,
wherein the ball valve set comprises a first ball valve and a second ball valve, the first ball valve is disposed at the return pipe of the compressor, and is configured to obstruct the return pipe of the compressor in a maintenance condition, and the second ball valve is disposed at the outlet pipe of the compressor, and is configured to obstruct the outlet pipe of the compressor in the maintenance condition.

3. The system for disconnecting the superconducting magnet from the refrigeration unit according to claim 1, further comprising a pressure gauge set for indicating pressures in the helium gas pipelines,
wherein the pressure gauge set comprises a first pressure gauge connected to the first two-position four-way valve, and a second pressure gauge connected to the second two-position four-way valve.

4. The system for disconnecting the superconducting magnet from the refrigeration unit according to claim 3, further comprising a needle valve set for pressure relief,
wherein the needle valve set comprises a first needle valve connected to the first two-position four-way valve, and a second needle valve connected to the second two-position four-way valve.

5. The system for disconnecting the superconducting magnet from the refrigeration unit according to claim 4, further comprising an adjustable pressure relief valve,
wherein the adjustable pressure relief valve is connected to the first two-position four-way valve and is configured to discharge residual gas out of the helium gas pipelines.

6. The system for disconnecting the superconducting magnet from the refrigeration unit according to claim 1, wherein, in a disconnected operation state,
the power supply is in a de-energized state;
each of the first helium gas pipeline and the second helium gas pipeline is in a disconnected state; and
the first two-position four-way valve is adjusted to bring the cold head into the disconnected operation condition, and the second two-position four-way valve is adjusted to bring the compressor into the balanced pressure condition.

7. The system for disconnecting the superconducting magnet from the refrigeration unit according to claim 5, wherein
the adjustable pressure relief valve starts to be opened for pressure relief when a cracking pressure of the adjustable pressure relief valve is reached, and is automatically closed once the pressure relief is completed.

8. The system for disconnecting the superconducting magnet from the refrigeration unit according to claim 1, wherein, in a reconnection state,
the power supply is in an energized state;
each of the first helium gas pipeline and the second helium gas pipeline is in a communicated state; and
the first two-position four-way valve is adjusted to bring the cold head into the reconnection condition.

9. The system for disconnecting the superconducting magnet from the refrigeration unit according to claim 5, further comprising a maintenance state,
wherein the maintenance state comprises a maintenance state on an on-board side, a maintenance state on a ground side, and a setting state of the adjustable pressure relief valve, the on-board side refers to a side where the cold head is located, and the ground side refers to a side where the compressor is located.

10. The system for disconnecting the superconducting magnet from the refrigeration unit according to claim 9, wherein
in the maintenance state on the on-board side, the first two-position four-way valve is adjusted to bring the cold head into the disconnected operation condition, and the first needle valve is opened to empty the helium gas pipelines on the on-board side and then is closed;
in the maintenance state on the ground side, the second two-position four-way valve is adjusted to bring the compressor into the balanced pressure condition, and the second needle valve is opened to empty the helium gas pipelines on the ground side and then is closed; and
in the setting state of the adjustable pressure relief valve, the first two-position four-way valve is adjusted to bring the cold head into the disconnected operation condition, and the adjustable pressure relief valve is adjusted while observing the first pressure gauge, until the first pressure gauge indicates a required set pressure.
